(19) Europäisches Patentamt
European Patent Office
Office européen des brevets

(11) **EP 3 201 373 B1**

(12) **EUROPÄISCHE PATENTSCHRIFT**

(45) Veröffentlichungstag und Bekanntmachung des Hinweises auf die Patenterteilung:
**12.09.2018 Patentblatt 2018/37**

(21) Anmeldenummer: **15781597.8**

(22) Anmeldetag: **29.09.2015**

(51) Int Cl.:
*C23C 4/08* *(2016.01)*          *C23C 4/134* *(2016.01)*
*H01L 35/08* *(2006.01)*          *H01L 35/34* *(2006.01)*

(86) Internationale Anmeldenummer:
**PCT/EP2015/072427**

(87) Internationale Veröffentlichungsnummer:
**WO 2016/050770 (07.04.2016 Gazette 2016/14)**

(54) **PLASMA-BESCHICHTEN VON THERMOELEKTRISCHEM AKTIVMATERIAL MIT NICKEL UND ZINN**

PLASMA COATING OF THERMOELECTRIC ACTIVE MATERIAL WITH NICKEL AND TIN

APPLICATION PAR PLASMA D'UN REVÊTEMENT DE NICKEL ET D'ÉTAIN SUR UN MATÉRIAU ACTIF THERMOÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.09.2014 DE 102014219756**

(43) Veröffentlichungstag der Anmeldung:
**09.08.2017 Patentblatt 2017/32**

(73) Patentinhaber: **Evonik Degussa GmbH**
**45128 Essen (DE)**

(72) Erfinder:
• **BUSSE, Jens**
**44879 Bochum (DE)**
• **HOCH, Sascha**
**44797 Bochum (DE)**
• **KERN, Magdalena**
**63755 Alzenau (DE)**
• **GIESSELER, Mareike**
**63477 Maintal (DE)**
• **SCHULTZ, Thorsten**
**64739 Hassenroth (DE)**
• **STENNER, Patrik**
**63452 Hanau (DE)**

(56) Entgegenhaltungen:
WO-A2-2012/120060          WO-A2-2013/144107
DE-A1-102012 017 556       US-A- 3 909 241

**Beschreibung**

Die Erfindung betrifft ein Verfahren zur Herstellung eines Thermoschenkels für ein thermoelektrisches Bauelement, bei welchem mit Hilfe einer Plasmaflamme auf einem thermoelektrischen Aktivmaterial eine Diffusionsbarriere aus Nickel aufgebracht wird; bzw. bei welchem mit Hilfe einer Plasmaflamme auf einer Diffusionsbarriere aus Nickel eine Kontaktvermittlerschicht aus Zinn aufgebracht wird. Ferner betrifft die Erfindung ein thermoelektrisches Bauelement mit Thermoschenkeln, die entsprechend hergestellt sind.

Ein thermoelektrisches Bauelement ist ein Energiewandler, welcher thermische Energie unter Ausnutzung des von Peltier und Seebeck beschriebenen thermoelektrischen Effekts in elektrische Energie umsetzt. Da der thermoelektrische Effekt reversibel ist, kann jedes thermoelektrische Bauelement auch zur Umsetzung von elektrischer Energie in thermische Energie genutzt werden: So genannte Peltier-Elemente dienen unter elektrischer Leistungsaufnahme zum Kühlen bzw. Wärmen von Objekten. Peltier-Elemente verstehen sich daher auch als thermoelektrische Bauelemente. Thermoelektrische Bauelemente, die zur Umwandlung von thermischer Energie in elektrische Energie dienen, werden oft als thermoelektrische Generatoren (TEG) bezeichnet.

Beispiele und Einführungen zu thermoelektrischen Bauelementen finden sich unter:

- Thermoelectrics Goes Automotive, D. Jänsch (ed.), expert verlag GmbH, 2011, ISBN 978-3-8169-3064-8;
- JP2006032850A;
- EP0773592A2;
- US6872879B1;
- US20050112872A1;
- JP2004265988A.

Technisch ausgeführte thermoelektrische Bauelemente umfassen mindestens ein aus zwei Thermoschenkeln gebildetes Thermopaar aus thermoelektrischem Aktivmaterial und ein das Thermopaar tragendes und/oder umschließendes und elektrisch nach außen hin isolierendes Substrat.

Im Stand der Technik ist eine Vielzahl von thermoelektrischen Aktivmaterialien beschrieben. Für den kommerziellen Einsatz eignen sich beispielsweise Legierungen aus der Klasse der halbleitenden Wismuthtelluride (insbesondere mit zusätzlichen Anteilen von Selen und/oder Antimon), aus welchen sich - einerseits p-leitend und andererseits n-leitend dotiert - ein Thermopaar aufbauen lässt.

Weitere thermoelektrisch aktive Stoffklassen sind: Halb-Heusler-Materialien, verschiedene Silizide (insbesondere Magnesium, Eisen), verschiedene Skutterudite, verschiedene Telluride (Blei, Zinn, Lanthan, Antimon, Silber), verschiedene Antimonide (Zink, Cer, Eisen, Ytterbium, Mangan, Cobalt, Wismut; Teilweise auch als Zintl-Phasen bezeichnet), TAGS, Siliziumgermanide, Clathrate (insbes. auf Germanium-Basis). Neben diesen Halbleitermaterialien lassen sich thermoelektrische Bauelemente auch aus Kombinationen der meisten gewöhnlichen Metalle herstellen, wie dies z.B. bei handelsüblichen Thermoelementen zur Temperaturmessung der Fall ist, z. B. Ni-CrNi. Jedoch sind die so erzielbaren sog. Gütezahlen (thermoelektrische "Wirkungsgrade") deutlich geringer als bei den genannten Halbleitermaterialien.

In thermoelektrischen Bauelementen müssen die aus Aktivmaterial bestehenden Thermoschenkel elektrisch mit metallischen Leitern (so genannte "Kontaktbrücken") zu einem Thermopaar kontaktiert werden, wobei ein sehr geringer elektrischer Widerstand durch die Fügestelle hindurch gewährleistet sein muss. Gleichzeitig muss verhindert werden, dass Atome aus dem metallischen Leiter und/oder den zur elektrischen Verbindung verwendeten Lote und Lothilfsmittel, oder Stoffe, die bei anderen Fügeverfahren zum Einsatz kommen, in die Aktivmaterialien hineindiffundieren, was zu unerwünschten Veränderungen ihrer thermoelektrischen Eigenschaften führen könnte. Dies kann durch Aufbringen einer Diffusionsbarriere auf dem thermoelektrischen Aktivmaterial unterbunden werden. Klassisches geeignetes Barrierematerial für viele der derzeit verwendeten Aktivmaterialien ist Nickel.

Beim Aufbringen der Diffusionsbarriere auf dem thermoelektrischen Aktivmaterial sind allgemein die folgenden Gesichtspunkte zu beachten:

- Schaffung einer wirksamen und dabei möglichst dünnen Diffusionsbarriere mit geeigneter Homogenität, Dichtigkeit und Schichtstärke;
- Hoher elektrischer Durchgangswiderstand der aufgebrachten Schicht(en), sowie geringe elektrische Übergangswiderstände in allen Kontaktzonen unterschiedlicher Schichten;
- Geringe Investitions- und Betriebskosten für die Beschichtung, um die Herstellungskosten des thermoelektrischen Bauelements gering zu halten, denn nur so lässt es sich wirtschaftlich nutzen;
- Das Beschichtungsverfahren muss geeignet sein für die Massenproduktion, es muss gut skalierbar und einfach beherrschbar sein, es muss eine gleichbleibende Qualität und hohe Durchsätze liefern und es muss einfach an geänderte Geometrien und/oder Werkstoffe anpassbar sein;
- Es muss einen gleichmäßigen und gut steuerbaren Schichtaufbau liefern;
- Es muss eine gleichmäßige und gute Haftung auf unterschiedlichen TE-Aktivmaterialien liefern;
- Es dürfen nur geringe Verluste an Beschichtungsmaterial auftreten;
- Die Toxizität von feinverteilten Metallen (insbes. von Nickel) ist zu beherrschen;
- das Verfahren muss einen örtlich definierbaren Schichtaufbau liefern, nämlich nur an der zu beschichtenden Oberfläche des Aktivmaterials, in der Regel im Bereich der späteren Kontaktstelle zu dem Leiter; Abscheidungen an Stellen, die nicht erwünscht oder überflüssig sind, zu vermeiden, auch ist die Bildung von unerwünschten elektrischen Verbindungen zwischen benachbarten TE-Schenkeln unerwünscht;

- das Verfahren sollte robust gegenüber Qualitätsschwankungen der eingesetzten Beschichtungsmaterialien sein sowie der zu beschichtenden Aktivmaterialien

- das Verfahren sollte einen stoffschlüssigen Übergang ermöglichen;

- Schließlich soll das Verfahren eine gute mechanische und elektrische Anbindbarkeit an gängige elektrische Leitermaterialien wie Kupfer, Silber, Aluminium, Zinn, oder Gold sicherstellen.

Das Aufbringen der Diffusionsbarriere auf dem Aktivmaterial erfolgt in der industriellen Praxis durch Nickel-Sputtern, galvanische Beschichtung, Flammspritzen oder CVD/PVD-Beschichtung.

Die herkömmlichen Beschichtungstechnologien weisen vielfältige Nachteile auf:
Das Nickel-Sputtern ist ein aufwändiges und teures Verfahren, welches Hochvakuum und hochreine Nickel-Targets benötigt. Es bietet nur geringe Durchsätze wegen der Hochvakuumkammer und der begrenzten Nickel-Abtragsrate vom Target. Außerdem ist hier ein hoher Nickel-Verbrauch wegen geringer Ausnutzung zu beklagen, da die Abscheidung auf nahezu allen Oberflächen der Vakuumkammer erfolgt. Schließlich ist der Energieverbrauch immens. Dasselbe gilt im Prinzip auch für CVD/PVD-Technologie.
Die galvanische Beschichtung erzielt nur eine begrenzte Haftung auf Halbleitern. Außerdem stellt sie sehr hohe Anforderungen an Reinigung der Aktivfläche und Sauberkeit allgemein. Die aggressiven Galvanikbäder können Halbleiter und andere Bauteile des TE-Elements oder auch die Gegenelektrode angreifen, darüber hinaus sind sie hochgradig toxisch und umweltgefährlich.

Zu kritisieren ist auch, dass ein gleichmäßiger Schichtaufbau eine homogene Stromdichteverteilung erfordert. Dies ist in der Praxis aufgrund oft inhomogener Halbleiter und oberflächlicher Oxidschichten/Verunreinigungen auf den Aktivmaterialien kaum zu erreichen.

Bei simultaner Beschichtung mehrerer TE-Schenkel sorgen unterschiedliche Innenwiderstände und Kontaktwiderstände der Schenkel ebenfalls für stark inhomogene Stromverteilung auf den Schenkeln. Deswegen ist eine simultane Beschichtung von n- und p-Schenkeln in der Regel nicht möglich.

Die elektrische Kontaktierung einer Vielzahl an TE-Schenkeln bei gleichzeitiger Vermeidung des Kontaktes der Kontaktierungszone mit flüssigen Galvanikbädern ist konstruktiv sehr aufwändig.

Die Gegenelektroden unterliegen aufgrund der aggressiven Bäder einem hohen Verschleiß und sind deswegen teuer. Auch können an ihnen giftige und/oder korrosive Stoffe gebildet werden.

Schließlich verändert sich die Badzusammensetzung während der galvanischen Beschichtung, was die gleichmäßige Abscheidung bzw. Steuerung des Prozesses erschwert.

Das Flammspritzen stellt auch keine bessere Alternative dar. So ist hier typisch ein inhomogener und schwer steuerbarer Schichtaufbau und eine begrenzte örtliche Kontrollierbarkeit der Abscheidung. Die Flamme muss nämlich eine gewisse Mindestgröße erzielen, um Nickelpulver hinreichend aufheizen zu können. Deswegen ist Flammspritzen nicht für filigrane Strukturen unterhalb einiger Millimeter Durchmesser geeignet. Flammgespritzte Barriereschichten weisen oft eine hohe Porosität und damit eine ungenügende Dichtheit auf.

Außerdem lässt sich bei Flammspritzen ein Sandstrahl-Effekt beobachten, der zu einer Abtragung des Aktivmaterials führt.

Die Haftung flammgespritzter Barriereschichten auf Halbleiter-Aktivmaterial ist oft ungenügend, hervorgerufen durch Oxidbildung an Nickel und Halbleitern durch Oxidationsmittel in der Flamme. Dies führt zu einem hohen elektrischen Widerstand an der Kontaktstelle des Thermoschenkels, wodurch der Wirkungsgrad des TE-Moduls sinkt.

In der WO2013/144106A1 wird das Aufbringen einer Diffusionsbarriere aus Nickel auf thermoelektrischem Aktivmaterial durch Aufpressen und Aufsintern einer aus einer Folie ausgestanzten Scheibe offenbart. Außerdem erwähnt diese Schrift in Zusammenhang mit dem Aufbringen von Barrierematerial das Pulver-Plasmaspritzen, ohne jedoch auf Details einzugehen.

Nachteil des Aufpressens und Aufsinterns ist, dass der gesamte TE-Schenkel auf die Sintertemperatur des Nickels gebracht werden muss. Diese kann für viele TE-Halbleiter zu hoch sein. Auch führt die Verwendung einer Folie zu dickeren Schichten, als für die Barrieredichtheit notwendig. Außerdem muss die Versinterung unter mechanischem Druck erfolgen und dauert verhältnismäßig lange, was Durchsatz und Maschinenausnutzung begrenzt.

Aus der WO2008/077608A2 ist ein Verfahren zum Aufspritzen einer Leiterbahn auf ein Substrat bekannt, bei welchem ein Metallpulver mit Hilfe eines kalten Plasmas bei atmosphärischen Bedingungen auf das Substrat aufgebracht wird und dort die Leiterbahn ausbildet. Als Beschichtungsmaterial nennt diese Schrift konkret Zinn und Kupfer. Im Ausführungsbeispiel wird Zinnpulver verwendet mit einer Teilchengröße im Bereich von 1 $\mu$m bis 100 $\mu$m Partikeldurchmesser. Weitergehende Angaben zur Beschaffenheit des Pulvers fehlen. Nach Aussage dieser Schrift ist eine Vorbehandlung des zu beschichtenden Substrats nicht erforderlich. Thermoelektrisches Aktivmaterial wird nicht beschichtet.

Aus der WO2013/144107 A2 ist ein Verfahren zur Herstellung eines Thermoschenkels für ein thermoelektrisches Bauelement offenbart, bei welchem mit Hilfe einer Plasmaflamme auf einem thermoelektrischen Aktivmaterial eine Diffusionsbarriere aus Nickel aufgebracht wird.

In der CH401186 ist ein Verfahren zur Herstellung von Thermoschenkeln für ein thermoelektrisches Bauelement beschrieben, bei welchem mit Hilfe einer heißen Plasmaflamme auf einem thermoelektrischen Aktivmaterial eine Diffusionsbarriere aus Nickel aufgebracht wird. Als Vorbehandlung vor der Beschichtung wird eine Reinigung von oxidiertem Material empfohlen, insbesondere durch Sandstrahlen, um die Oberfläche aufzurauen und die Haftung der Diffusionsbarriere zu verbessern. Ebenso beschreibt diese Schrift, wie auf die Diffusionsbarriere eine zweite Schicht beispielsweise aus Kupfer oder Eisen aufgebracht werden kann, um ein Auflöten eines elektrischen Kontakts auf den Thermoschenkel zu erleichtern. Allerdings fehlen auch hier konkrete Angaben zur Beschaffenheit des Pulvers.

Versuche der Anmelderin mit am Markt erhältlicher Plasma-Spritztechnologie pulverförmiges Nickel auf thermoelektrisches Aktivmaterial aufzuspritzen, um darauf eine Diffusionsbarriere zu bilden, schlugen fehl.

Die Erfinder sahen sich folglich mit der Aufgabe konfrontiert, die herkömmliche Plasma-Spritztechnologie so weiterzubilden, sodass sich damit industriellen Maßstab Thermoschenkel herstellen lassen.

Gelöst wurde diese Aufgabe dadurch, dass Nickelpartikel verwendet werden, die eine mittlere Sphärizität von größer 0,74 aufweisen.

Die Erfinder haben nämlich erkannt, dass ein Schlüssel zur erfolgreichen Herstellung einer Diffussionsbarriere aus Nickel in der Beherrschung der Zuführung der Partikel in die Plasmaflamme liegt. Um auf thermoelektrischem Aktivmaterial eine Nickelschicht mit den oben geschilderten Eigenschaften abzuscheiden, muss offenbar der Plasmaflamme das Nickelpulver in einer besonderen Art und Weise zugeführt werden, die sich von der Zuführung anderer Metallpulvern unterscheidet. Ein einfacher Austausch bisher verarbeiteter Metallpulver durch Nickelpulver führte nicht zum Erfolg.

Erfindungsgemäß wird ein Nickelpulver eingesetzt, dessen Partikel eine besondere Sphärizität aufweisen.

Die "Sphärizität" $\Psi$ ist ein Maß für den Grad der Kugelform eines unregelmäßig geformten Körpers. Sie ist mathematisch definiert durch das Verhältnis der Oberfläche einer Kugel, welche das gleiche Volumen V wie der Körper aufweist, zur Oberfläche A des Körpers:

$$\Psi = \frac{\pi^{\frac{1}{3}}(6V)^{\frac{2}{3}}}{A}$$

Die Sphärizität $\Psi$ kann Werte zwischen Null und Eins annehmen. Eine ideale Kugel hat die Sphärizität 1. Je unregelmäßiger der Körper geformt ist, umso geringer ist seine Sphärizität: Ein Würfel mit drei gleich langen Kanten weist so etwa eine Sphärizität von etwa 0,8 auf.

Ein vergleichsweise spitzer Tetraeder erreicht lediglich eine Sphärizität von 0,67. Ein immerhin teilweise runder Zylinder weist hingegen eine höhere Sphärizität von 0,87 auf.

Der mathematische Begriff der Sphärizität beschreibt demnach die Rundheit der Partikel und kann als Indikator für das Fließverhalten von Pulver verwendet werden. Da ein Pulver aus einer Vielzahl einzelner Partikel unterschiedlicher individueller Sphärizität besteht, macht es Sinn, dem Pulver einen statistischen Gesamtwert der Sphärizität zuzuordnen. Dazu wird die Sphärizität einzelner Partikel bestimmt und daraus der Mittelwert gebildet. Man spricht dann von der mittleren Sphärizität *SM* einer Partikelschüttung.

Die Partikeltechnologie hat unterschiedliche Messmethoden entwickelt, die eine Bestimmung der Sphärizität eines Pulvers ermöglichen.

Bildverarbeitende Methoden ermöglichen das Erfassen der Form und können aus der Form und Größe die Sphäriztät errechnen. Bildverarbeitende Systeme gibt es dynamisch oder stationär. Dynamische Systeme z. B. Firma Sympatec Typ QicPic. Stationäre Systeme sind in optischen Mikroskopen oder Raster-Elektronen-Mikroskopen (REM) enthalten und werten einzelne Bilder aus.

Das QicPic der Firma Sympatec GmbH bestimmt die Sphärizität anhand des Verhältnisses des Umfangs des flächengleichen Kreises $P_{EQPC}$ zum tatsächlichen Umfang $P_{real}$. Es nutzt dabei einen zweidimensionalen Ansatz, der von dem mathematisch idealen dreidimensionalen Ansatz abweicht, aber dennoch eine gute Näherung bietet.

Nach dieser Messmethode wurde die mittlere Sphärizität der eingesetzten Pulver bestimmt. Versuche zeigen, dass ein Nickelpulver mit einer mittleren Spärizität SM größer 0,74 ein Fließverhalten zeigt, welches es erlaubt, die Nickelpartikel kontinuierlich einer Plasmaflamme zuzuführen, sodass damit eine zuverlässig dichte Diffusionsbarriere geschaffen werden kann. Ein unterbrochener Partikelstrom ist nämlich tunlichst zu vermeiden, da andernfalls die für diesen Einsatzzweck notwendige Homogenität und Dicke der Schicht nicht eingehalten werden kann. Idealerweise beträgt die mittlere Sphärizität 0,79.

Gegenstand der Erfindung ist mithin ein Verfahren zur Herstellung eines Thermoschenkels für ein thermoelektrisches Bauelement, bei welchem mit Hilfe einer Plasmaflamme auf einem thermoelektrischen Aktivmaterial eine Diffusionsbarriere aus Nickel aufgebracht wird, bei welchem der Plasmaflamme Nickelpartikel zugeführt werden, die eine mittlere Sphärizität SM von größer 0,74 aufweisen.

Besonders bevorzugt ist eine mittlere Sphärizität SM im Bereich von 0,78 bis 0,8, in dem der optimale Wert von 0,79 liegt.

Diese Werte beziehen sich auf Messungen mit dem QicPic der Firma Sympatec GmbH.

Neben der Sphärizität wirkt sich auch die Partikelgrößenverteilung des eingesetzten Nickelpulvers maßgeblich auf die Prozessierbarkeit des Pulvers und somit auf die erzielte Beschichtungsgüte aus. Eine bevorzugte Weiterbildung der Erfindung sieht es deswegen vor Nickelpartikel zu verwenden, die hinsichtlich ihrer Partikelgrößenverteilung die folgende Spezifikation aufweisen:

$D_{50}$ von 0.6 μm bis 25 μm, wobei 4 μm bis 7 μm bevorzugt ist.

Unter der Partikelgrößenverteilung $D_{50}$ ist zu verstehen, dass 50 % der eingesetzten Partikel einen Äquivalenzdurchmesser in dem beanspruchten Bereich aufweisen. Der Äquivalenzdurchmesser ist der Durchmesser einer Kugel, die das gleiche Volumen aufweist wie der unregelmäßige Partikel. Eine für Nickelpulver geeignete Messmethode ist die statische Lichtstreuung. Ein geeignetes Gerät ist die. Retsch Horiba LA-950.

Ein geeignetes Nickelpulver, dessen Partikel sowohl die geforderte Sphärizität als auch die vorteilhafte Partikelgrößenverteilungen aufweisen, erhält man dadurch, dass die Partikel sprühgetrocknet und gesichtet werden. Beim Sprühtrocknen wird flüssiges Nickel in einem Gasstrom verdüst, sodass die flüssigen Nickeltropfen eine zur Verringerung ihrer Oberflächenspannung eine kugelige Form anstreben. Im Gasstrom verfestigt (getrocknet) behalten die Partikel ihre kugelige Form bei, sodass sie eine hohe Sphärizität erreichen.

Diese Partikel dürfen danach nicht mehr vermahlen werden, da durch den Mahlprozess die runden Partikel wieder abgeplattet werden und/oder scharfkantig aufbrechen. So weist vermahlenes Pulver bei einem gleichen $D_{50}$-Wert eine mittlere Sphärizität von 0,47 auf und kann deswegen nicht erfindungsgemäß eingesetzt werden.

Aus diesem Grunde muss die Einstellung der gewünschten Partikelgrößenverteilung durch Sichtung erfolgen. Sichten ist ein Klassierverfahren, bei welchem die Partikel mit der gewünschten Größe aus dem sprühgetrockneten Grobpulver ausgewählt werden. Beim Windsichten wird der Feinanteil dadurch abgetrennt, dass die kleinen Partikel langsamer in dem Gasstrom sedimentieren.

Da nach dem Sprühtrocknen kein Arbeitsschritt mehr erfolgt, der eine Verkleinerung der Partikelgrößenverteilung bewirkt, liegen die einsetzbaren Nickelpartikel grundsätzlich schon nach der Sprühtrocknung vor, sie müssen nur noch aus der Gesamtmenge der sprühgetrockneten Nickelpulvers ausgewählt werden. Deswegen kommt der Sprühtrocknung der Nickelpartikel eine besondere Bedeutung zu.

Neben der Beschaffenheit des Partikelpulvers sind auch die Prozessparameter der Plasma-Beschichtungsanlage bedeutsam:

Plasma-Beschichtungsanlagen sind kommerziell erhältlich. Ihr Herzstück bildet eine Düse, in der ein Trägergasstrom aus einem ionisierbaren Gas einströmt. In die Düse wird auch der Metallpulver gefördert und darin in dem Trägergasstrom dispergiert. Das Trägergas wird durch eine Ionisierungszone geführt, in der sich eine elektrische Hochspannung entlädt. Konkret weist dazu die Düse eine Anode und eine Kathode auf, zwischen denen die Spannung sich durch Funkenüberschlag entlädt. Das Trägergas strömt durch den Bereich der Entladung hindurch und wird dabei ionisiert, das heißt gleichsinnig ionisch aufgeladen. Das ionisierte Trägergas mit den darin dispergierten Partikeln verlässt die Düse als Plasmastrom und trifft auf die zu beschichtende Oberfläche des thermoelektrischen Aktivmaterials. Die Nickelpartikel scheiden sich so auf dem Aktivmaterial ab.

In der Plasma-Flamme wird die Oberfläche der Metallpartikel nämlich derart aktiviert, dass sich diese bei Auftreffen auf die Zieloberfläche an dieser anhaften und eine Schicht ausbilden können. Gegebenenfalls versintert sogar das Beschichtungsmaterial mit dem darunter liegendem Substrat, also dem Aktivmaterial bzw. dem ersten Beschichtungsmaterial.

Als ionisierbares Trägergas wird vorzugsweise Stickstoff ($N_2$) oder Wasserstoff ($H_2$) oder Mischungen daraus eingesetzt. Vorzugsweise wird Formiergas, das ist eine Mischung aus 95 Vol.-% Stickstoff und 5 Vol.-% Wasserstoff als Trägergas verwendet. Der Wasserstoffanteil gibt dem Plasmastrom eine reduzierende Wirkung, welche die Entfernung von unerwünschten Oxidschichten auf dem thermoelektrischen Aktivmaterial ermöglicht. Dadurch sinkt der thermische und elektrische Widerstand der Kontaktstelle, sodass die Effizienz des späteren thermoelektrischen Bauelements steigert wird. Der hohe Stickstoffanteil unterdrückt die Neuoxidation und senkt das Explosionsrisiko.

Zur Ionisierung wird bevorzugt eine gepulste Gleichspannung zwischen 10 kV und 50 kV bei einer Pulsfrequenz zwischen 15 kHz und 25 kHz verwendet.

Die Prozesseffizienz wird aber gesteigert, wenn die Ionisation und Dispersion gleichzeitig in der Düse erfolgt. Nichtdestotrotz sind kommerziell verfügbare Plasmadüsen so aufgebaut, dass zuerst die Ionisierung des Trägergases erfolgt und das Pulver unmittelbar danach, also vor Austritt aus der Düse in bereits ionisiertes Trägergas dispergiert wird.

Die Temperatur der Plasmaflamme sollte auf einen Wert unter 3000 K eingestellt werden, damit das thermoelektrische Aktivmaterial nicht beschädigt wird. Die Plasmatemperatur ist abhängig vom Prozessgas, der Leistung und dem Druck. Entscheidend ist jedoch die Temperatur auf dem Substrat. Hier darf der Schmelzpunkt des Halbleiters nicht überschritten werden. Die Temperatur auf dem Substrat wird weiterhin beeinflusst von der Fahrgeschwindigkeit des Plasmastiftes. Es muss eine ausreichende Plasmatemperatur gewählt werden um das Nickel oberflächlich zu aktivieren und eine Temperatur auf dem Substrat ohne es zu zerstören.

Konkret erfolgt die Plasma-Beschichtung wie folgt:

a) das Trägergas wird mit einem Volumenstrom von 10 Nl/min bis 60 Nl/min in die Düse gefördert wird, wobei 30 Nl/min bevorzugt ist;

b) das Trägergas wird in der Düse ionisiert, indem es durch ein von der elektrischen Spannung hervorgerufene elektrische Entladung hindurchgeführt wird;

c) die Nickelpartikel werden mit einer Förderrate von 1 g/min bis 10 g/min in die Düse gefördert, wobei 3.5 g/min bevorzugt ist;

d) die Nickelpartikel werden in dem Strom des Trägergases dispergiert, wobei dies vor oder nach oder während der Ionisierung des Trägergases erfolgt;

e) die Plasmaflamme tritt aus der Düse in Richtung der thermoelektrischen Aktivmaterials aus;

f) Düse und thermoelektrisches Aktivmaterial werden bei gleichbleibenden Abstand relativ zueinander bewegt mit einem Vorschub von 80 mm/s bis 250 mm/s, wobei ein Vorschub von 200 mm/s bevorzugt ist;
dergestalt,

g) dass über die Plasmaflamme die der Düse zugeführten Nickelpartikel aufdem thermoelektrischen Aktivmaterial abgeschieden werden, sodass die Diffusionsbarriere mit einer Schichtdicke von 3 $\mu$m bis 100 $\mu$m auf den thermoelektrischen Aktivmaterial aufwächst, wobei eine Schichtdicke von 10 $\mu$m bis 20$\mu$m bevorzugt ist.

Soweit erfindungsgemäße Partikel eingesetzt werden, lassen sich auf diese Weise Diffusionsbarrieren aus Nickel in hervorragender Qualität bei einem Durchsatz produzieren, der einer industriellen Massenfertigung von thermoelektrischen Bauelementen gerecht wird.

Thermoelektrisches Aktivmaterial wie Wismuth-Tellurid weist oft eine Oxidschicht auf, die auf dem Halbleiter durch Kontakt mit Luftsauerstoff entsteht. Solche Oxidschichten wirken als elektrischer und thermischer Isolator, sodass sie im Interesse einer hohen Energieeffizienz des thermoelektrischen Bauteils diese Oxidschichten zumindest im Bereich der späteren Diffusionsbarriere, über welche der elektrische Kontakt hergestellt wird, zu entfernen sind.

Eine besonders bevorzugte Ausführungsform der Erfindung sieht es vor, dass vor dem Aufbringen der Diffusionsbarriere das thermoelektrische Aktivmaterial im Bereich der späteren Diffusionsbarriere mit einer Plasmaflamme behandelt wird, in welcher keine Partikel dispergiert sind, wobei die Plasmaflamme ohne dispergierte Partikel analog zu der Plasmaflamme mit darin dispergierten Nickelpartikel erzeugt wird, mit dem Unterschied, dass der Plasmaflamme ohne dispergierte Partikel keine Nickelpartikel zugeführt werden.

Dieser Weiterbildung liegt die Idee zu Grunde, die Plasmaflamme, die zur Beschichtung genutzt wird, vor der Beschichtung auch für die Entfernung der Oxidschichten zu nutzen. Dafür wird ein reduzierendes Trägergas verwendet wie Wasserstoff oder Formiergas, welches die Oxidschichten reduziert. Der Reinigungsflamme werden keine Partikel zudosiert. Im Übrigen können die Parameter der Beschichtungsanlage beibehalten werden. Dieselbe Anlage und Werkstückeinrichtung kann so genutzt werden, um Oxidschichten auf dem Aktivmaterial vor der Beschichtung zu entfernen. Dies macht die Fertigung besonders rationell. Gegenüber der Reinigung mit einem Sandstrahl hat die Verwendung der Plasmaflamme ohne Partikelzugabe den Vorteil, dass die Oberfläche des Aktivmaterial mechanisch nicht so stark beschädigt wird.

Die Barriereschicht wird unmittelbar auf die frisch im Plasmastrahl gereinigte Kontaktfläche des Halbleiters (sowohl von n- als auch p-Typ) aufgebracht - somit besteht keine Gefahr der Neuverschmutzung oder Neuoxidation der Kontaktfläche durch Wartezeiten oder Anlagenschnittstellen. Um eine Neuoxidation zu vermeiden, sollte der Prozess unter Schutzatmosphäre durchgeführt werden.

Ein Vorteil der Erfindung ist darin zu sehen, dass ein Vakuum oder Überdruck nicht nötig sind. Es wird lediglich eine Einhausung benötigt, um eine Inertisierung mit dem Schutzgas zur Vermeidung von Oxidbildung zu realisieren, sowie Freisetzung feinteiliger Metalle in die Umgebung zu verhindern.

Vorteil der Erfindung ist auch, dass es bei Atmosphärendruck betrieben werden kann. Demgemäß wird das Verfahren etwa bei Atmosphärendruck betrieben, sodass der absolute Druck der Schutzatmosphäre zwischen $0.8*10^5$ Pa und $1.2*10^5$ Pa liegt.

Zur Sicherstellung der Inertisierung und damit zur Vermeidung von ungewünschter Oxidbildung sollte der Sauerstoffanteil in der Schutzatmosphäre unter 100ppm Vol.-% liegen. Insbesondere wird als Schutzatmosphäre Stickstoff mit einer Reinheit von mindestens 99,9 Vol.-% verwendet.

In der Regel wird man auf die Diffusionsbarriere aus Nickel nicht direkt eine elektrische Kontaktbrücke aus einem elektrischen Leiter wie Kupfer oder Aluminium auflöten sondern dazwischen eine Kontaktvermittlerschicht vorsehen, welche die Kontaktierung des Lotes auf der Nickelschicht verbessert. Erfindungsgemäß wird die Kontaktvermittlerschicht aus Zinn ebenfalls mit Hilfe des Plasma-Spritzens auf die Nickelbarriere aufgebracht, vorzugsweise auf derselben Anlage. Allerdings kann das dabei zu verarbeitende Zinnpulver nicht willkürlich ausgewählt werden, es sollte vielmehr eine mittlere Sphärizität SM von größer 0,72 aufweisen. Der ideale Wert liegt bei SM=0,77, sodass der darum liegende Bereich von 0,75<SM< 0,8 besonders bevorzugt ist. Diese Werte beziehen sich wieder auf Messungen mit dem QicPic der Firma Sympatec GmbH.

Da die Verwendung eines Zinnpulvers mit einer besonderen Sphärizität demselben Erfindungsgedanken entspricht wie bei der Auswahl des Nickel-Pulvers, ist ein Verfahren zur Herstellung eines Thermoschenkels für ein thermoelektrisches Bauelement, bei welchem mit Hilfe einer Plasmaflamme auf einer Diffusionsbarriere aus Nickel eine Kontaktvermittlerschicht bestehend aus Zinn aufgebracht wird, und bei welchem der Plasmaflamme Zinnpartikel zugeführt werden, welche hinsichtlich ihrer Sphärizität die genannte Spezifikation erfüllen, ebenfalls Gegenstand der Erfindung.

Die Kontaktvermittlerschicht braucht nicht zwingend auf einer erfindungsgemäß Plasmagespritzten Barriereschicht aufgebracht zu werden, es macht aber durchaus Sinn, beide Prozessschritte erfindungsgemäß auf derselben Anlage durchzuführen.

Beim Plasmaspritzen mit Zinn sollten die folgenden Parameter eingehalten werden:
Es sollten Zinnpartikel mit einer Partikelgrößenverteilung verwendet werden, die die folgende Spezifikation erfüllen:
$D_{50}$ von 1 μm bis 40 μm, wobei 18 μm bis 22 μm bevorzugt ist.

Zinnpulver mit passender Sphärizität und Partikelgrößenverteilung sind durch Sprühtrocknung und Sichtung erhältlich.

Bei der Plasmaflamme zum Zinnspritzen handelt es sich um einen Strom eines ionisierten Trägergases, in welchem die Zinnpartikel dispergiert sind,

a) wobei ein Trägergas eingesetzt wird, welches ausgewählt aus Stickstoff, Wasserstoff oder Mischungen daraus, wobei Luft als Trägergas bevorzugt ist;

b) wobei das Trägergas mit Hilfe einer elektrischen Spannung ionisiert wird, insbesondere mit einer gepulsten Gleichspannung zwischen 10 kV und 50 kV bei einer Pulsfrequenz zwischen 15 kHz und 25 kHz;

c) wobei die Temperatur der Plasmaflamme unter 3000 K liegt.

Die Plasmaflamme zum Zinnspritzten wird in einer Düse erzeugt, indem

a) das Trägergas mit einem Volumenstrom von 10 Nl/min bis 60 Nl/min in die Düse gefördert wird, wobei 30 Nl/min bevorzugt ist;

b) das Trägergas in der Düse ionisiert wird, indem es durch eine von der elektrischen Spannung hervorgerufene elektrische Entladung hindurchgeführt wird;

c) die Zinnpartikel mit einer Förderrate von 1 g/min bis 10 g/min in die Düse gefördert werden, wobei 3.5 g/min bevorzugt ist;

d) die Zinnpartikel in dem Strom des Trägergases dispergiert werden, wobei dies vo oder nach oder während der Ionisierung des Trägergases erfolgt;

e) die Plasmaflamme aus der Düse in Richtung der Diffusionsbarriere austritt;

f) und die Düse und Diffusionsbarriere bei gleichbleibenden Abstand relativ zueinander bewegt werden mit einem Vorschub von 80 mm/s bis 250 mm/s, wobei ein Vorschub von 200 mm/s bevorzugt ist; dergestalt,

g) dass über die Plasmaflamme die der Düse zugeführten Zinnpartikel auf der Diffusionsbarriere abgeschieden werden, sodass die Kontaktvermittlungsschicht mit einer Schichtdicke von 20 μm bis 200 μm auf der Diffusionsbarriere aufwächst, wobei eine Schichtdicke von 50 μm bis 100 μm bevorzugt ist.

Sowohl für die Plasma-Beschichtung mit Nickel als auch mit Zinn gelten mithin ähnliche technologische Randbedingungen, was die Einheitlichkeit der Erfindung unterstreicht.

Maßgeblich ist auch in beiden Fällen die Fließfähigkeit der Partikel, welche eine entsprechende Zuführbarkeit ermöglicht. Die Zuführung der Nickel- bzw. Zinn-Partikel in die Plasma-Flamme erfolgt pneumatisch. Pulver mit erfindungsgemäßer Sphärizität lassen sich damit hervorragend kontinuierlich fördern, auch mit den im industriellen Maßstab geforderten Massenströmen. Der Anteil des Volumenstroms für die pneumatische Förderung ist sehr gering im Vergleich zu dem Gasstrom durch das Plasma.

Im Übrigen wurde hinsichtlich des Aktivmaterials gefunden, dass das Aktivmaterial während der Beschichtung auf etwa 80 °C aufgeheizt werden sollte, da dies das Aufwachsen der Beschichtung verbessert. Eine Weiterbildung der Erfindung sieht mithin vor, dass die zu beschichtende Oberfläche des thermoelektrischen Aktivmaterials vor der Reinigung und/oder vor Beschichtung auf eine Temperatur von 60 °C bis 100 °C, insbesondere von 80 °C temperiert wird.

Grundsätzlich können alle eingangs genannten thermoelektrischen Aktivmaterialien mit der erfindungsgemäßen Technologie beschichtet werden. Versuche zeigen allerdings, dass Wismuthtelluride sich besonders gut beschichten lassen, auch dann, wenn diese mit Anteilen von Antimon und/oder Selen versetzt sind.

Insgesamt zielt der erfindungsgemäße Prozess die folgenden Vorteile:
Der örtlich sehr begrenzte Energieeintrag in die Metallpulver sowie in die von der Plasmaflamme bestrichene Oberfläche des zu beschichtenden Werkstückes reduziert die Aufheizung des Werkstückes und ermöglicht sogar die Beschichtung temperaturempfindlicher Werkstoffe, wie insbesondere viele TE-Halbleiter oder aber auch thermoelektrisch passiver Substrate, welche die Thermoschenkel umgeben oder umhüllen.

Ein besonderer Vorteil des erfindungsgemäßen Beschichtungsverfahrens ist, dass der reduzierende Charakter der Plasmaflamme sowie die Inertisierung durch die Schutzatmosphäre die Bildung von unerwünschten Metalloxiden vermeiden. Dies verbessert die Haftung, verringert den Widerstand und verbessert damit den Wirkungsgrad des TE-Moduls.

Ein weiterer Vorteil des Verfahrens ist, dass n- und p-Schenkel unter den gleichen Bedingungen metallisiert werden können. Eine Temperaturanpassung aufgrund der unterschiedlichen Sintertemperaturen der beiden unterschiedlich dotierten Halbleiter ist nicht notwendig. Dies vereinfacht die Prozessführung und damit die Kosten.

Des Weiteren erschließt die Erfindung die Möglichkeit, lediglich eine Bearbeitungsstation für drei Bearbeitungsschritte, sowie für den p- und n-Schenkeltyp zu nutzen. Geeignete Bearbeitungsstationen für das Atmosphärendruck-Plasmaspritzen sind zu geringen Investitionskosten von der Stange verfügbar, kompakt und gut zu automatisieren.

Vorteilhafterweise ermöglicht die Erfindung den vollständigen Einschluss gefährlicher Stoffe, nämlich der feinpulverigen Schwermetalle Nickel und Zinn. Dieser ist im Prozess intrinsisch gegeben durch die notwendige Inertgaseinhausung.

Ein Vorteil der Erfindung ist auch, dass Kapazitätsanpassungen einfach durch Parallelisierung mehrerer identischer Stationen möglich sind.

Auch ist die flexible Strukturierung durch programmierbare 3D-Positionierung der Spritzköpfe und Einstellbarkeit des Metall-Mengenstroms möglich, d. h. schnelle Anpassbarkeit an spezielle Anforderungen. Auch Kleinserien sind kostengünstig darstellbar.

Die erfindungsgemäß aufgebrachte Metallschicht kann stark porös bis beinahe porenfrei eingestellt werden, abhängig von den gewählten Plasma-Einstellungen und der zugeführten Metallpulver. Es ist möglich, durch Aufbringen einer ausreichend dicken Schicht eine komplett von Durchgangsporen freie Beschichtung herzustellen und so die darunter liegende Struktur vollständig vor Einwirkung von Fluiden zu schützen bzw. eine wirksame Diffusionsbarriere zur Unterbindung von Metallatom-Wanderung zwischen elektrischem Leiter und thermoelektrischem Halbleiter zu erzeugen.

Die erfindungsgemäßen Verfahren zur Beschichtung von thermoelektrischem Aktivmaterial mit Nickel und Zinn führen zu Thermoschenkeln mit hervorragender Beschichtungsgüte. Zwei derartig beschichtete Thermoschenkel lassen sich zu durch Auflöten einer Kontaktbrücke auf die beschichteten Stellen zu einem Thermopaar verschalten, welches Bestanteil eines thermoelektrischen Bauelements sein kann.

Da ein solches von der im erfindungsgemäßen Verfahren erzielbaren hohen Beschichtungsgüte profitiert, ist ein thermoelektrisches Bauelement, umfassend mindestens zwei Thermoschenkel aus thermoelektrischem Aktivmaterial, welche über eine Kontaktbrücke elektrisch leitend zu einem Thermopaar verschaltet sind, ebenfalls Gegenstand der Erfindung, sofern mindestens einer der Thermoschenkel nach dem erfindungsgemäßen erhältlich ist oder erhalten ist.

Die Erfindung soll nun anhand von Figuren näher erläutert werden. Hierfür zeigen

Figur 1:     Prinzipskizze;

Figur 2:     Thermoschenkel aus Aktivmaterial in passivem Substrat mit Ni/Sb-Beschichtung (erstes Arbeitsergebnis);

Figur 3:     Thermoschenkel aus Aktivmaterial in passivem Substrat mit Ni/Sb-Beschichtung (zweites Arbeitsergebnis);

Figur 4:     Thermoschenkel aus Aktivmaterial mit Ni/Sb-Beschichtung (drittes Arbeitsergebnis);

Figur 5:     Thermoschenkel aus Aktivmaterial mit Ni/Sb-Beschichtung (viertes Arbeitsergebnis).

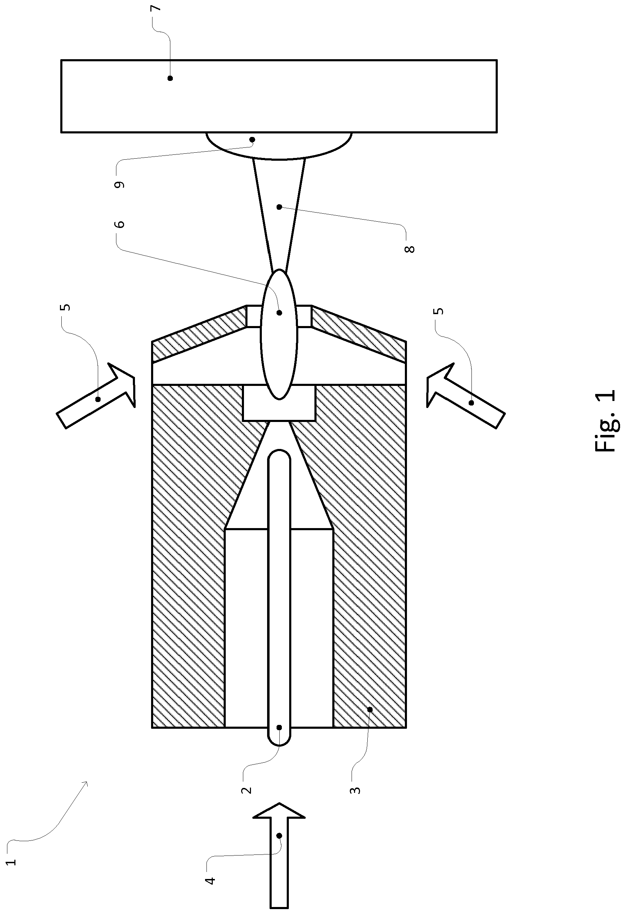

Figur 1 zeigt eine Prinzipskizze des erfindungsgemäßen Plasmaspritzens. Eine Düse 1 umfasst eine Kathode 2 und eine Anode 3. Die Kathode 2 ist um die Anode 3 herum angeordnet. Zwischen Kathode 2 und Anode 3 wird eine Hochspannung angelegt. Bei der Hochspannung handelt es sich um eine gepulste Gleichspannung von 20 kV. Die Pulsfrequenz beträgt 20 kHz. Die Spannung entlädt sich zwischen Anode 3 und Kathode 2 durch Funkenüberschlag.

Durch die Düse 1 strömt ein Trägergas 4, welches durch den die Entladung der Hochspannung zwischen Anode und Kathode ionisiert wird. In den Mündungsbereich der Düse 1 wird ein metallisches Beschichtungsmaterial 5 (Nickel bzw. Zinn) pulverförmig eingetragen. Dies geschieht pneumatisch mit einem nicht ionisierten Fördergas wie Argon. In der Düse 1 wird das pulverförmige Beschichtungsmaterial 5 in dem Trägergas 4 dispergiert, sodass ein Beschichtungsgasstrom 6 aus der Düse 1 austritt.

Die Düse wird auf das zu beschichtende thermoelektrische Aktivmaterial 7 ausgerichtet. Bei Annäherung wird der Lichtbogen gezündet. Über das Plasma 8 wird das pulverförmige Beschichtungsmaterial 5 auf die zu beschichtende Oberfläche des thermoelektrischen Aktivmaterials 7 abgeschieden. Ein nicht dargestellter Manipulator bewegt das Aktivmaterial 7 relativ zu der feststehenden Düse 1, sodass auf der Oberfläche des Aktivmaterials eine Schicht 9 aus Beschichtungsmaterial aufwächst. Die Relativbewegung findet innerhalb eines mit Schutzatmosphäre gefüllten Raums statt, genauer gesagt, in einer Einhausung des Beschichtungsapparats. Je nach eingesetztem Beschichtungsmaterial 5 (Nickel oder Zinn) handelt es sich bei der aufgebrachten Schicht 9 um eine Diffusionsbarriere oder eine Kontaktvermittlerschicht.

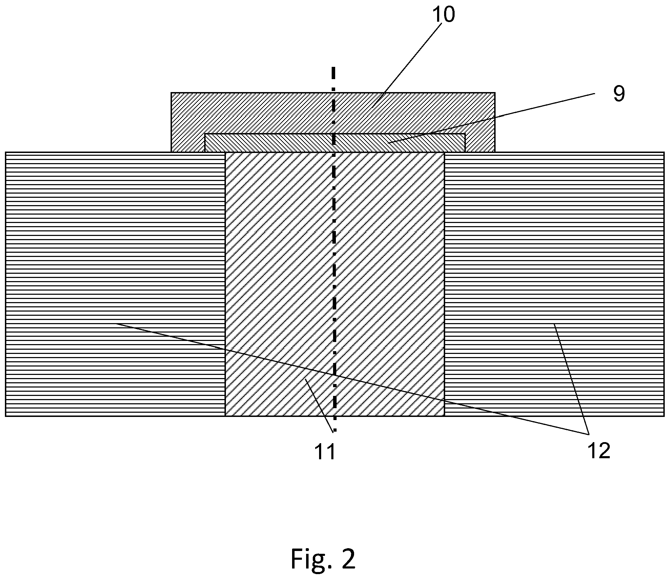

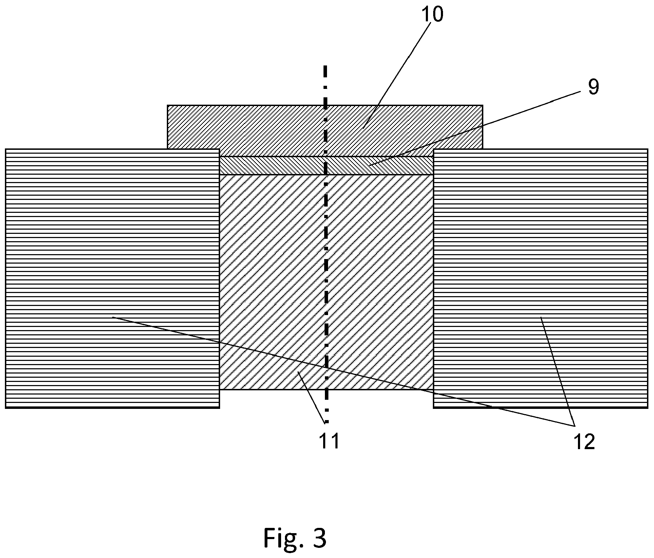

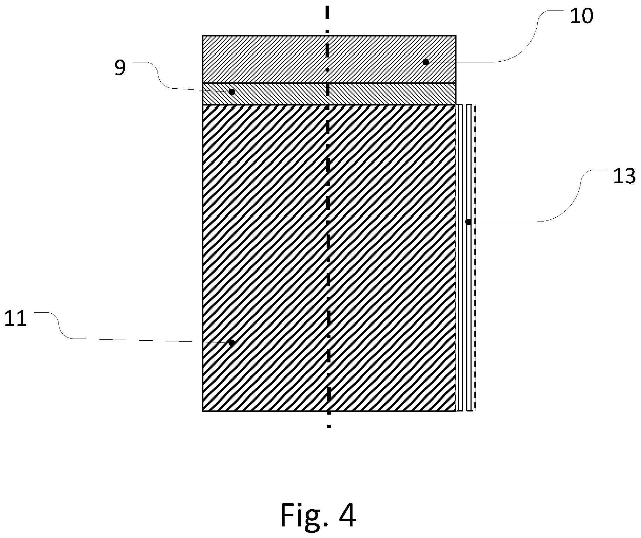

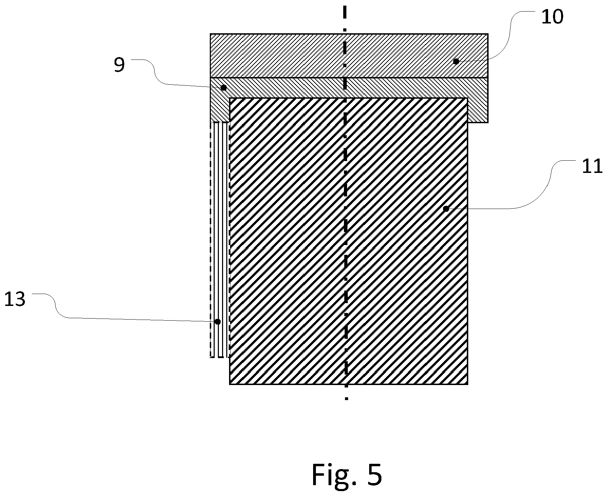

Die Figuren 2 bis 5 zeigen diverse Arbeitsergebnisse, bei denen eine erste Schicht 9 aus Nickel als Diffusionsbarriere und darauf eine zweite Schicht 10 aus Zinn als Kontaktvermittlerschicht auf Thermoschenkel 11 aus thermoelektrischem Aktivmaterial erfindungsgemäß aufgetragen wurde. Der Thermoschenkel 11 befindet sich bei den in den Figuren 2 und 3 gezeigten Arbeitsergebnissen in einem thermoelektrisch passiven Substrat 12 aus einem keramischen Verbundmaterial. Die Thermoschenkel 11 bei den in den Figuren 4 und 5 gezeigten Arbeitsergebnissen sind an ihren Flanken, außerhalb ihres elektrischen Kontaktbereiches, mit einer optionalen Schutzschicht 13 versehen, die ebenfalls erfindungsgemäß aufgebracht wurde. Es lassen sich also nicht nur die elektrischen Kontaktstellen des Aktivmaterials erfindungsgemäß beschichten sondern auch andere Oberflächenbereiche, die Diffusion und Oxidation ausgesetzt sind.

**Bezugszeichenliste**

1    Düse
2    Kathode
3    Anode
4    Trägergas
5    Beschichtungsmaterial (pulverförmig)
6    Beschichtungsgasstrom
7    thermoelektrisches Aktivmaterial
8    Plasma
9    erste Schicht Ni (Diffusionsbarriere)
10   zweite Schicht Sb (Kontaktvermittler)
11   Thermoschenkel
12   Substrat
13   Schutzschicht

**Patentansprüche**

1. Verfahren zur Herstellung eines Thermoschenkels für ein thermoelektrisches Bauelement, bei welchem mit Hilfe einer Plasmaflamme auf einem thermoelektrischen Aktivmaterial eine Diffusionsbarriere aus Nickel aufgebracht wird,
   **dadurch gekennzeichnet,**
   **dass** der Plasmaflamme Nickelpartikel mit einer mittleren Sphärizität größer als 0,74 zugeführt werden.

2. Verfahren nach Anspruch 1, **dadurch gekennzeichnet, dass** die Nickelpartikel hinsichtlich ihrer Partikelgrößenverteilung die folgende Spezifikation erfüllen: $D_{50}$ von 0.6 $\mu$m bis 25 $\mu$m, wobei 4 $\mu$m bis 7 $\mu$m bevorzugt ist.

3. Verfahren nach Anspruch 2, **dadurch gekenn-**

**zeichnet, dass** sprühgetrocknete und gesichtete Nickelpartikel verwendet werden.

4. Verfahren nach Anspruch 1, 2 oder 3 unter der Maßgabe, dass es sich bei der Plasmaflamme um einen Strom eines ionisierten Trägergases handelt, in welchem die Nickelpartikel dispergiert sind, **dadurch gekennzeichnet,**

   a) **dass** ein Trägergas eingesetzt wird, welches ausgewählt aus Stickstoff, Wasserstoff oder Mischungen daraus, wobei eine Mischung aus 95 Vol.-% Stickstoff und 5 Vol.-% Wasserstoff als Trägergas bevorzugt ist;
   b) **dass** das Trägergas mit Hilfe einer elektrischen Spannung ionisiert wird, insbesondere mit einer gepulsten Gleichspannung zwischen 10 kV und 50 kV bei einer Pulsfrequenz zwischen 15 kHz und 25 kHz;
   c) **dass** die Temperatur der Plasmaflamme unter 3000 K liegt.

5. Verfahren nach Anspruch 4, unter der Maßgabe, dass die Plasmaflamme in einer Düse erzeugt wird, **dadurch gekennzeichnet,**

   a) **dass** das Trägergas mit einem Volumenstrom von 10 Nl/min bis 60 Nl/min in die Düse gefördert wird, wobei 30 Nl/min bevorzugt ist;
   b) **dass** das Trägergas in der Düse ionisiert wird, indem es durch ein von der elektrischen Spannung hervorgerufene elektrische Entladung hindurchgeführt wird;
   c) **dass** die Nickelpartikel mit einer Förderrate von 1 g/min bis 10 g/min in die Düse gefördert werden, wobei 3.5 g/min bevorzugt ist;
   d) **dass** die Nickelpartikel in dem Strom des Trägergases dispergiert werden, wobei dies vor oder nach oder während der Ionisierung des Trägergases erfolgt;
   e) **dass** die Plasmaflamme aus der Düse in Richtung der thermoelektrischen Aktivmaterials austritt;
   f) und **dass** Düse und thermoelektrisches Aktivmaterial bei gleichbleibenden Abstand relativ zueinander bewegt werden mit einem Vorschub von 80 mm/s bis 250 mm/s, wobei ein Vorschub von 200 mm/s bevorzugt ist; dergestalt,
   g) **dass** über die Plasmaflamme die der Düse zugeführten Nickelpartikel auf dem thermoelektrischen Aktivmaterial abgeschieden werden, sodass die Diffusionsbarriere mit einer Schichtdicke von 3 $\mu$m bis 100 $\mu$m auf den thermoelektrischen Aktivmaterial aufwächst, wobei eine Schichtdicke von 10 $\mu$m bis 20$\mu$m bevorzugt ist.

6. Verfahren nach einem der vorhergehenden Ansprüche, **dadurch gekennzeichnet, dass** vor dem Aufbringen der Diffusionsbarriere das thermoelektrische Aktivmaterialim Bereich der späteren Diffusionsbarriere mit einer Plasmaflamme behandelt wird, in welcher keine Partikel dispergiert sind, wobei die Plasmaflamme ohne dispergierte Partikel analog zu der Plasmaflamme mit darin dispergierten Nickelpartikel erzeugt wird, mit dem Unterschied, dass der Plasmaflamme ohne dispergierte Partikel keine Nickelpartikel zugeführt werden.

7. Verfahren zur Herstellung eines Thermoschenkels für ein thermoelektrisches Bauelement, insbesondere nach einem der Ansprüche 1 bis 6, bei welchem mit Hilfe einer Plasmaflamme auf einer Diffusionsbarriere aus Nickel eine Kontaktvermittlerschicht aufgebracht wird,
**dadurch gekennzeichnet,**
**dass** die Kontaktvermittlerschicht aus Zinn besteht, und dass der Plasmaflamme Zinnpartikel mit einer mittleren Sphärizität größer als 0,72 zugeführt werden.

8. Verfahren nach Anspruch 7, **dadurch gekennzeichnet, dass** die Zinnpartikel hinsichtlich ihrer Partikelgrößenverteilung die folgende Spezifikation erfüllen: $D_{50}$ von 1 $\mu$m bis 40 $\mu$m, wobei 18 $\mu$m bis 22 $\mu$m bevorzugt ist.

9. Verfahren nach Anspruch 8, **dadurch gekennzeichnet, dass** sprühgetrocknete und gesichtete Zinnpartikel verwendet werden.

10. Verfahren nach Anspruch 7, 8 oder 9 unter der Maßgabe, dass es sich bei der Plasmaflamme um einen Strom eines ionisierten Trägergases handelt, in welchem die Zinnpartikel dispergiert sind,
**dadurch gekennzeichnet,**

a) **dass** ein Trägergas eingesetzt wird, welches ausgewählt aus Stickstoff, Wasserstoff oder Mischungen daraus, wobei Luft als Trägergas bevorzugt ist;
b) **dass** das Trägergas mit Hilfe einer elektrischen Spannung ionisiert wird, insbesondere mit einer gepulsten Gleichspannung zwischen 10 kV und 50 kV bei einer Pulsfrequenz zwischen 15 kHz und 25 kHz;
c) **dass** die Temperatur der Plasmaflamme unter 3000 K liegt.

11. Verfahren nach Anspruch 10, unter der Maßgabe, dass die Plasmaflamme in einer Düse erzeugt wird,
**dadurch gekennzeichnet,**

a) **dass** das Trägergas mit einem Volumenstrom von 10 Nl/min bis 60 Nl/min in die Düse gefördert wird, wobei 30 Nl/min bevorzugt ist;

b) **dass** das Trägergas in der Düse ionisiert wird, indem es durch eine von der elektrischen Spannung hervorgerufene elektrische Entladung hindurchgeführt wird;
c) **dass** die Zinnpartikel mit einer Förderrate von 1 g/min bis 10 g/min in die Düse gefördert werden, wobei 3.5 g/min bevorzugt ist;
d) **dass** die Zinnpartikel in dem Strom des Trägergases dispergiert werden, wobei dies vor oder nach oder während der Ionisierung des Trägergases erfolgt;
e) **dass** die Plasmaflamme aus der Düse in Richtung der Diffusionsbarriere austritt;
f) und **dass** Düse und Diffusionsbarriere bei gleichbleibenden Abstand relativ zueinander bewegt werden mit einem Vorschub von 80 mm/s bis 250 mm/s, wobei ein Vorschub von 200 mm/s bevorzugt ist;
dergestalt,
g) **dass** über die Plasmaflamme die der Düse zugeführten Zinnpartikel auf der Diffusionsbarriere abgeschieden werden, sodass die Kontaktvermittlungsschicht mit einer Schichtdicke von 20 $\mu$m bis 200 $\mu$m auf der Diffusionsbarriere aufwächst, wobei eine Schichtdicke von 50 $\mu$m bis 100 $\mu$m bevorzugt ist.

12. Verfahren einem der vorhergehenden Ansprüche, **dadurch gekennzeichnet, dass** die Nickelpartikel und/oder die Zinnpartikel mit Hilfe einer pneumatischen Förderung der Plasmaflamme zugeführt werden.

## Claims

1. Method for producing a thermoleg for a thermoelectric component in which a diffusion barrier of nickel is applied to a thermoelectric active material with the aid of a plasma flame, **characterized**
**in that** nickel particles with a mean sphericity of greater than 0.74 are fed to the plasma flame.

2. Method according to Claim 1, **characterized in that** the nickel particles conform to the following specification with regard to their particle size distribution: $D_{50}$ of 0.6 $\mu$m to 25 $\mu$m, with 4 $\mu$m to 7 $\mu$m being preferred.

3. Method according to Claim 2, **characterized in that** spray-dried and screened nickel particles are used.

4. Method according to Claim 1, 2 or 3, with the proviso that the plasma flame is a stream of an ionized carrier gas in which the nickel particles are dispersed, **characterized**

a) **in that** a carrier gas that is chosen from nitrogen, hydrogen or mixtures thereof is used, a mixture of 95% by volume nitrogen and 5% by volume hydrogen being preferred as the carrier gas;

b) **in that** the carrier gas is ionized with the aid of an electrical voltage,

in particular with a pulsed DC voltage of between 10 kV and 50 kV with a pulse frequency of between 15 kHz and 25 kHz;

c) **in that** the temperature of the plasma flame lies below 3000 K.

5. Method according to Claim 4, with the proviso that the plasma flame is produced in a nozzle, **characterized**

a) **in that** the carrier gas is fed into the nozzle with a volumetric flow of 10 Nl/min to 60 Nl/min, with 30 Nl/min being preferred;

b) **in that** the carrier gas is ionized in the nozzle by being passed through an electrical discharge induced by the electrical voltage;

c) **in that** the nickel particles are fed into the nozzle at a feed rate of 1 g/min to 10 g/min, with 3.5 g/min being preferred;

d) **in that** the nickel particles are dispersed in the stream of carrier gas, this taking place before or after or during the ionization of the carrier gas;

e) **in that** the plasma flame leaves the nozzle in the direction of the thermoelectric active material;

f) and **in that** the nozzle and the thermoelectric active material are moved in relation to one another, while maintaining the same distance, with an advancement of 80 mm/s to 250 mm/s, an advancement of 200 mm/s being preferred;

in such a way

g) that the nickel particles fed to the nozzle are deposited on the thermoelectric active material by means of the plasma flame, and so the diffusion barrier grows on the thermoelectric active material with a layer thickness of 3 $\mu$m to 100 $\mu$m, a layer thickness of 10 $\mu$m to 20 $\mu$m being preferred.

6. Method according to one of the preceding claims, **characterized in that**, before the application of the diffusion barrier, the thermoelectric active material is treated in the region of the later diffusion barrier with a plasma flame in which no particles are dispersed, the plasma flame without dispersed particles being produced in a way analogous to the plasma flame with nickel particles dispersed in it, with the difference that no nickel particles are fed to the plasma flame without dispersed particles.

7. Method for producing a thermoleg for a thermoelectric component, in particular according to one of Claims 1 to 6, in which a contact maker layer is applied to a diffusion barrier of nickel with the aid of a plasma flame,

**characterized**

**in that** the contact maker layer consists of tin, and in that tin particles with a mean sphericity of greater than 0.72 are fed to the plasma flame.

8. Method according to Claim 7, **characterized in that** the tin particles conform to the following specification with regard to their particle size distribution:

$D_{50}$ of 1 $\mu$m to 40 $\mu$m, with 18 $\mu$m to 22 $\mu$m being preferred.

9. Method according to Claim 8, **characterized in that** spray-dried and screened tin particles are used.

10. Method according to Claim 7, 8 or 9, with the proviso that the plasma flame is a stream of an ionized carrier gas in which the tin particles are dispersed, **characterized**

a) **in that** a carrier gas that is chosen from nitrogen, hydrogen or mixtures thereof is used, air being preferred as the carrier gas;

b) **in that** the carrier gas is ionized with the aid of an electrical voltage,

in particular with a pulsed DC voltage of between 10 kV and 50 kV with a pulse frequency of between 15 kHz and 25 kHz;

c) **in that** the temperature of the plasma flame lies below 3000 K.

11. Method according to Claim 10, with the proviso that the plasma flame is produced in a nozzle, **characterized**

a) **in that** the carrier gas is fed into the nozzle with a volumetric flow of 10 Nl/min to 60 Nl/min, with 30 Nl/min being preferred;

b) **in that** the carrier gas is ionized in the nozzle by being passed through an electrical discharge induced by the electrical voltage;

c) **in that** the tin particles are fed into the nozzle at a feed rate of 1 g/min to 10 g/min, with 3.5 g/min being preferred;

d) **in that** the tin particles are dispersed in the stream of carrier gas, this taking place before or after or during the ionization of the carrier gas;

e) **in that** the plasma flame leaves the nozzle in the direction of the diffusion barrier;

f) and **in that** the nozzle and the diffusion barrier are moved in relation to one another, while maintaining the same distance, with an advancement of 80 mm/s to 250 mm/s, an advancement of 200 mm/s being preferred;

in such a way

g) that the tin particles fed to the nozzle are deposited on the diffusion barrier by means of the plasma flame, and so the contact maker layer grows on the diffusion barrier with a layer thickness of 20 μm to 200 μm, a layer thickness of 50 μm to 100 μm being preferred.

12. Method one of the preceding claims, **characterized in that** the nickel particles and/or the tin particles are fed to the plasma flame with the aid of pneumatic feeding

**Revendications**

1. Procédé de fabrication d'une branche thermique pour un composant thermoélectrique, selon lequel une barrière de diffusion en nickel est appliquée à l'aide d'une flamme plasma sur un matériau actif thermoélectrique, **caractérisé en ce que** des particules de nickel ayant une sphéricité moyenne supérieure à 0,74 sont introduites dans la flamme plasma.

2. Procédé selon la revendication 1, **caractérisé en ce que** les particules de nickel satisfont la spécification suivante au regard de leur distribution de tailles de particules :
$D_{50}$ de 0,6 μm à 25 μm, de préférence de 4 μm à 7 μm.

3. Procédé selon la revendication 2, **caractérisé en ce que** des particules de nickel séchées par pulvérisation et tamisées sont utilisées.

4. Procédé selon la revendication 1, 2 ou 3, à condition que la flamme plasma soit un courant de gaz vecteur ionisé dans lequel des particules de nickel sont dispersées, **caractérisé en ce que**

   a) un gaz vecteur est utilisé, qui est choisi parmi l'azote, l'hydrogène ou leurs mélanges, un mélange de 95 % en volume d'azote et 5 % en volume d'hydrogène étant préféré en tant que gaz vecteur ;
   b) le gaz vecteur est ionisé à l'aide d'une tension électrique, notamment avec une tension continue pulsée comprise entre 10 kV et 50 kV à une fréquence d'impulsions comprise entre 15 kHz et 25 kHz ;
   c) la température de la flamme plasma est inférieure à 3 000 K.

5. Procédé selon la revendication 4, à condition que la flamme plasma soit générée dans une buse, **caractérisé en ce que**

   a) le gaz vecteur est transporté à un débit volumique de 10 Nl/min à 60 Nl/min dans la buse, de préférence de 30 Nl/min ;

   b) le gaz vecteur est ionisé dans la buse par passage dans une décharge électrique produite par la tension électrique ;
   c) les particules de nickel sont transportées dans la buse à une vitesse de transport de 1 g/min à 10 g/min, de préférence de 3,5 g/min ;
   d) les particules de nickel sont dispersées dans le courant du gaz vecteur, ceci ayant lieu avant ou après ou pendant l'ionisation du gaz vecteur ;
   e) la flamme plasma sort de la buse dans la direction du matériau actif thermoélectrique ;
   f) et la buse et le matériau actif thermoélectrique sont déplacés à un écart constant l'un par rapport à l'autre avec un déplacement de 80 mm/s à 250 mm/s, un déplacement de 200 mm/s étant préféré ;
   de telle sorte que
   g) les particules de nickel introduites dans la buse soient déposées sur le matériau actif thermoélectrique par la flamme plasma, de telle sorte que la barrière de diffusion croisse à une épaisseur de couche de 3 μm à 100 μm sur le matériau actif thermoélectrique, une épaisseur de couche de 10 μm à 20 μm étant préférée.

6. Procédé selon l'une quelconque des revendications précédentes, **caractérisé en ce qu'**avant l'application de la barrière de diffusion, le matériau actif thermoélectrique est traité dans la zone de la barrière de diffusion ultérieure avec une flamme plasma dans laquelle aucune particule n'est dispersée, la flamme plasma sans particules dispersées étant générée de manière analogue à la flamme plasma dans laquelle des particules de nickel sont dispersées, avec comme différence qu'aucune particule de nickel n'est introduite dans la flamme plasma sans particules dispersées.

7. Procédé de fabrication d'une branche thermique pour un composant thermoélectrique, notamment selon l'une quelconque des revendications 1 à 6, selon lequel une couche de promoteur de contact est appliquée à l'aide d'une flamme plasma sur une barrière de diffusion en nickel, **caractérisé en ce que** la couche de promoteur de contact est constituée d'étain, et **en ce que** des particules d'étain ayant une sphéricité moyenne supérieure à 0,72 sont introduites dans la flamme plasma.

8. Procédé selon la revendication 7, **caractérisé en ce que** les particules d'étain satisfont la spécification suivante au regard de leur distribution de tailles de particules :
$D_{50}$ de 1 μm à 40 μm, de préférence de 18 μm à 22 μm.

9. Procédé selon la revendication 8, **caractérisé en ce que** des particules d'étain séchées par pulvérisation et tamisées sont utilisées.

10. Procédé selon la revendication 7, 8 ou 9, à condition que la flamme plasma soit un courant de gaz vecteur ionisé dans lequel des particules d'étain sont dispersées, **caractérisé en ce que**

    a) un gaz vecteur est utilisé, qui est choisi parmi l'azote, l'hydrogène ou leurs mélanges, l'air étant préféré en tant que gaz vecteur ;
    b) le gaz vecteur est ionisé à l'aide d'une tension électrique, notamment avec une tension continue pulsée comprise entre 10 kV et 50 kV à une fréquence d'impulsions comprise entre 15 kHz et 25 kHz ;
    c) la température de la flamme plasma est inférieure à 3 000 K.

11. Procédé selon la revendication 10, à condition que la flamme plasma soit générée dans une buse, **caractérisé en ce que**

    a) le gaz vecteur est transporté à un débit volumique de 10 Nl/min à 60 Nl/min dans la buse, de préférence de 30 Nl/min ;
    b) le gaz vecteur est ionisé dans la buse par passage dans une décharge électrique produite par la tension électrique ;
    c) les particules d'étain sont transportées dans la buse à une vitesse de transport de 1 g/min à 10 g/min, de préférence de 3,5 g/min ;
    d) les particules d'étain sont dispersées dans le courant du gaz vecteur, ceci ayant lieu avant ou après ou pendant l'ionisation du gaz vecteur ;
    e) la flamme plasma sort de la buse dans la direction de la barrière de diffusion ;
    f) et la buse et la barrière de diffusion sont déplacées à un écart constant l'une par rapport à l'autre avec un déplacement de 80 mm/s à 250 mm/s, un déplacement de 200 mm/s étant préféré ;
    de telle sorte que
    g) les particules d'étain introduites dans la buse soient déposées sur la barrière de diffusion par la flamme plasma, de telle sorte que la couche de promoteur de contact croisse à une épaisseur de couche de 20 $\mu$m à 200 $\mu$m sur la barrière de diffusion, une épaisseur de couche de 50 $\mu$m à 100 $\mu$m étant préférée.

12. Procédé l'une quelconque des revendications précédentes, **caractérisé en ce que** les particules de nickel et/ou les particules d'étain sont introduites dans la flamme plasma à l'aide d'un transport pneumatique.

Fig. 1

EP 3 201 373 B1

Fig. 2

EP 3 201 373 B1

EP 3 201 373 B1

**Fig. 3**

Fig. 4

EP 3 201 373 B1

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 2006032850 A
- EP 0773592 A2
- US 6872879 B1
- US 20050112872 A1
- JP 2004265988 A
- WO 2013144106 A1
- WO 2008077608 A2
- WO 2013144107 A2
- CH 401186

**In der Beschreibung aufgeführte Nicht-Patentliteratur**

- Thermoelectrics Goes Automotive. expert verlag GmbH, 2011